# EUROPEAN PATENT APPLICATION

(11) **EP 2 479 803 A2**
(43) Date of publication of application: **25.07.2012**
(21) Application number: 10817398.0
(22) Date of filing: 14.09.2010
(51) Int. Cl.: H01L 31/052, H01L 31/042

(54) **SUNLIGHT-COLLECTING APPARATUS**

(30) Priority: 15.09.2009 KR 20090086872
(71) Applicant: 3dS Family Co., Ltd., Cheoin-gu Yongin-si, Gyeonggi-do 449-872 (KR)
(72) Inventor: LEE, Seung Chul, Daegu 703-751 (KR)
(74) Representative: Mittler, Enrico
(86) International application number: PCT/KR2010/006272
(87) International publication number: WO 2011/034329

(57) **Abstract**

The present invention relates to a sunlight-collecting apparatus, comprises: a reflector panel (110) installed below a light-collecting panel (10) installed on an outer wall of a building; a supporting unit (120) configured as a fixing frame (121) coupled to each frame on the outer wall of the building to support the reflector panel (110); and an actuator unit (130) for controlling the angle of the reflector panel (110), wherein sunlight is effectively collected by the light-collecting panel (10) and reflector panel (110) to improve the efficiency of generating power from solar energy, and the angle of the reflector panel (110) installed below the light-collecting panel (110) is controlled by the actuator unit (130) to enable the more effective collection of sunlight.

## Description

### Technical Field

The present invention relates to a sunlight-collecting apparatus, and in particular to a sunlight-collecting apparatus which makes it possible to enhance the power generation of a solar energy in such a manner that a sunlight is effectively collected by installing a light-collecting panel at an outer wall of a portion between the floors of a building.

### Background Art

Solar energy power generation is a clean energy as compared with other power generations which clean energy does not produce air pollution, noises, vibrations or the same, and the transportation of fuel and a maintenance to power generation facilities are not needed, and the life span of apparatus is long, and a facility dimension selection and an installation construction are easy.

The solar energy power generation might be classified into a sun-tracing type, a semi-tracing type and a fixed array solar cell facility depending on how much the facility changes its sun-oriented direction as it traces the position of the sun in a direction vertical to the meridian of the sun so as to maximize the capacity of power generation.

A tracking array is directed to a way of tracing the position of the sun with the aid of a driving force or a device operation so a sunlight from the sun can be made incident on a front side of a solar cell plate all the time in a vertical direction which is conducted in an attempt to maximize the power generation efficiency of the photovoltaic system. The tracking array is generally classified into a global positioning programming system driven based on a sun meridian information and a photo sensor auto tracking system which systems are classified depending on the kinds of the tracking systems and are currently commercialized. The global positioning programming system based on the solar meridian information is advantageous to be simple and to have less problems; however it is disadvantageous to have a little bit lower efficiency as compare with the maximum solar power generation efficiency. The photo sensor auto tracking system is directed to a way of tracking the points where the intensities of light coming into two photo sensors are same after at least two photo sensors are attached, which system is advantageous to obtain the maximum energy efficiency all the time; however it is disadvantageous to cause a pumping phenomenon now that sunlight refracts when clouds pass by.

The semi-tracking array is directed to a way of changing upwards or downwards the positions of the slope angles of the solar cell array depending on the seasons or months. The way of changing the array slope angles one time per four seasons is generally called the semi-tracking array. The intensity of the electric power of the semi-tracking array is between the fixed array and the tracking array, thus obtaining an increase in the power generation by about 20% as compared with the fixed array.

The fixed array is not expensive and has a stable structure, so it is generally installed in a place where does not have any limits in an installation area in a remote area. It is more generally installed in a place where has a high wind speed as in remote island places.

The above fixed array is directed to an array support method in which the power generation efficiency is low as compared with the tracking array or the semi-tracking array; however it needs a small initial installation cost, and the risks for maintenance are low, which relatively results in increased use. The photovoltaic system for the purpose of remote island places in Korea is directed to the fixed array as standard one.

The building-integrated photovoltaic system (BIPV) is directed to decreasing a construction cost while enhancing the value of a building as it can be used as a design element by using the building-integrated solar module (module for BIPV) in addition to the provision of the electric power to customers, the electric power being generated from solar energies.

The above-mentioned technology can be very usefully applied when the topographic characteristics of Korea where lacks the aboveground installation area is considered.

The building-integrated photovoltaic system has limits in the shapes and the appearances of buildings despite the above some advantages, so it has been continuously demanded to develop the developments of a more efficient sunlight-collecting technology.

### Disclosure of Invention

Accordingly, it is intended that the present invention works out the above problems, and it is an object of the present invention to provide a sunlight-collecting apparatus which makes it possible to enhance a power generation efficiency of solar energy now what sunlight can be more effectively collected by installing a sunlight collecting panel at an outer wall between the floors of a building and a reflection panel at a lower side of the collecting panel.

It is another object of the present invention to provide a sunlight-collecting apparatus which is able to enhance a power generation efficiency of solar energy as sunlight can be effectively collected by adjusting the angles of the reflection panel installed at a lower side of a sunlight collecting plate of an outer wall between floors.

To achieve the above objects, there is provided a sunlight-collecting apparatus which comprises a reflection panel which is installed at a lower side of a sunlight-collecting panel installed at an outer wall of a building and has an angle adjusting frame at its lower surface, the insertion piece being formed by projecting a rear end of the angle adjusting frame toward the building; a support part which supports the reflection panel and is horizontally provided in multiple numbers by coupling the fixing frame at each frame of an outer wall of the building and forms a shaft hole at an outer side of the rotation guide member by coupling the rotation guide member at the fixing frame; and an operation part helping enhance a sunlight-collecting efficiency by adjusting the angle of the reflection panel, and a rotation shaft is inserted into and coupled to the rotation guide member formed at the fixing frame, and a connection piece is integrally coupled to an outer circumferential surface of the rotation shaft positioned at the left and right sides or one side of the rotation guide member and is made to operate in sync with the rotation shaft, and one side of the connection bar is pin-coupled to the other side of the connection piece, and the adjusting part is pin-coupled to the other side of the connection bar, and the connection bar and the insertion piece of the angle adjusting frame are pin-coupled to the adjusting part.

### Advantageous effects

The sunlight-collecting apparatus according to the present invention is characterized in that the angle of the reflection panel is adjusted to the optimum reflection angle depending on the change in position of the sun, and when a rotation shaft is rotated, a connection piece connected with the rotation shaft rotates in sync, and an adjusting part pin-connected to the connection piece by way of a connection bar moves upwards or downwards, and an angle adjusting frame pin-engaged with the adjusting part rotates, thus adjusting the angle of the reflection panel coupled to an upper side of the angle adjusting frame, so the optimum reflection angle can be maintained thereby, thus effectively reflecting a solar energy toward the sunlight-collecting panel, which leads to maximizing sunlight-correcting efficiency.

The present invention has advantageous effects that the power generation efficiency can be enhanced in such a way to install a sunlight-collecting panel at an outer wall between the floors of a building and a sunlight-correcting panel at a lower side of a sunlight-collecting panel, thus effectively collecting sunlight, and sunlight can be effectively collected by adjusting the angle of a reflection panel installed at a lower side of a sunlight-collecting panel.

### Best modes for carrying out the invention

Figure 1 is a perspective view illustrating a sunlight-collecting apparatus according to the present invention.

Figure 2 is a bottom perspective view illustrating a sunlight-collecting apparatus according to the present invention.

Figure 3 is a front view illustrating a sunlight-collecting apparatus according to the present invention.

Figure 4 is a front view illustrating a sunlight-collecting apparatus according to the present invention.

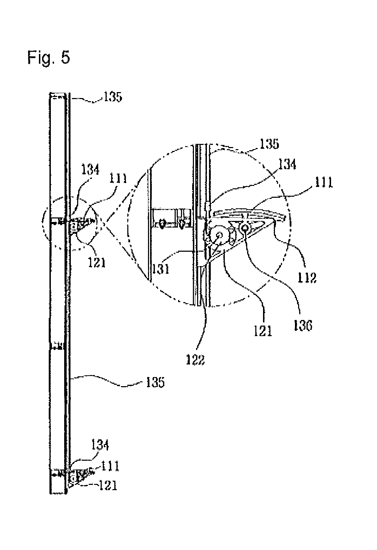

Figure 5 is a side view illustrating a sunlight-collecting apparatus according of the present invention.

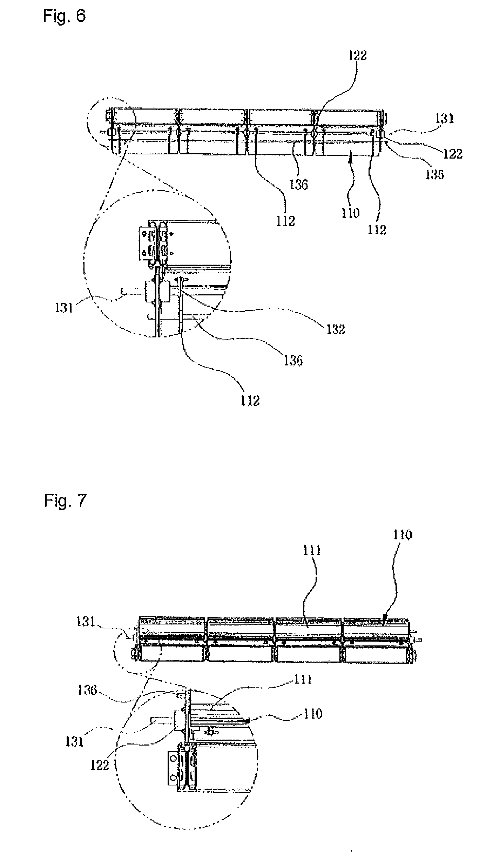

Figure 6 is a bottom view illustrating a sunlight-collecting apparatus according to the present invention.

Figure 7 is a plane view illustrating a sunlight-collecting apparatus according to the present invention.

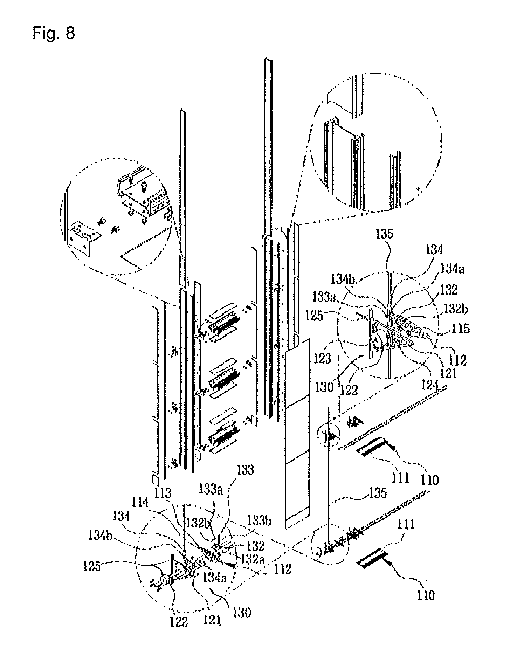

Figure 8 is a disassembled perspective view illustrating a sunlight-collecting apparatus according to the present invention.

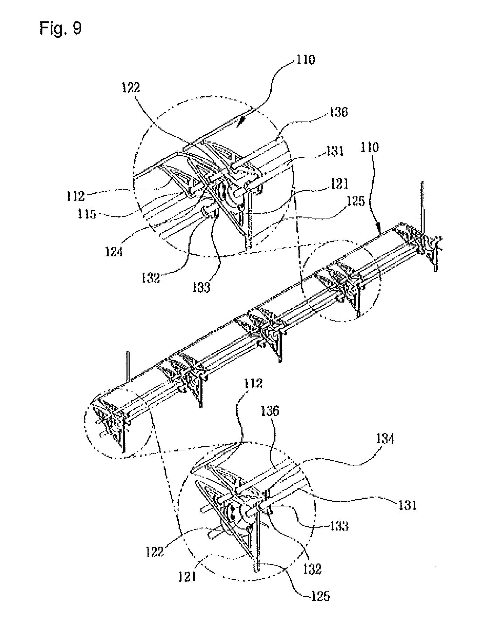

Figure 9 is a bottom perspective view illustrating a reflection panel of a sunlight-collecting apparatus according to the present invention.

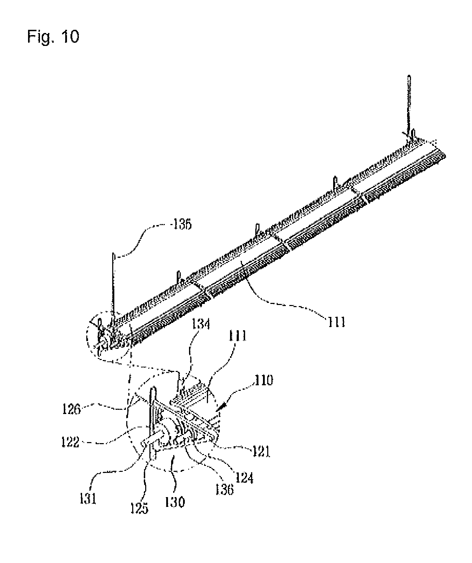

Figure 10 is a perspective view illustrating a reflection panel of a sunlight-collecting apparatus according to the present invention.

*Descriptions of reference numerals of key elements of the drawings*

| | |
|---|---|
| 1; sunlight-collecting apparatus | 10: sunlight-collecting panel |
| 110: reflection panel | 111: reflection surface |
| 112: angle adjusting frame | 113: insertion piece |
| 114: pin hole | 115: shaft hole |
| 120: support part | 121: fixing frame |
| 122: rotation guide member | 123: shaft hole |
| 124: shaft hole | 125: coupling chassis |
| 126: fixing member | 130: operation part |
| 131: rotation shaft | 132: connection piece |
| 132a: connection pin | 132b: pin hole |
| 133: connection bar | 133a; connection pin |
| 133b: pin hole | 134: adjusting part |
| 134a: insertion groove | 134b: pin hole |
| 135: connection rod | 136: guide shaft |

### Best modes for carrying out the invention

The preferred embodiments of the sunlight-collecting apparatus according to the present invention will be described in detail with reference to the accompanying drawings.

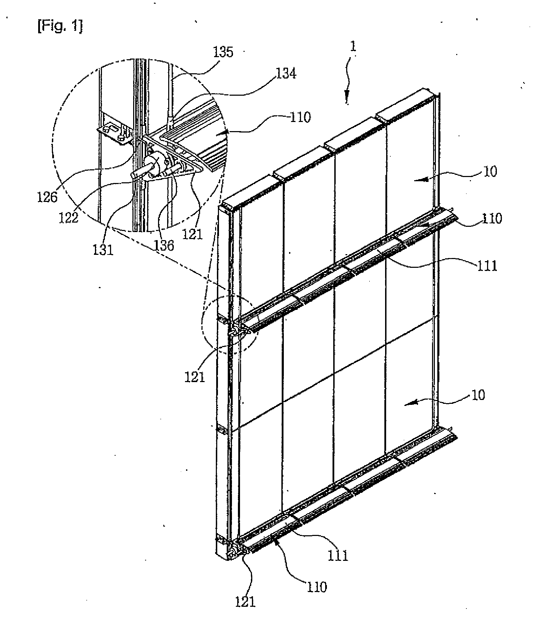

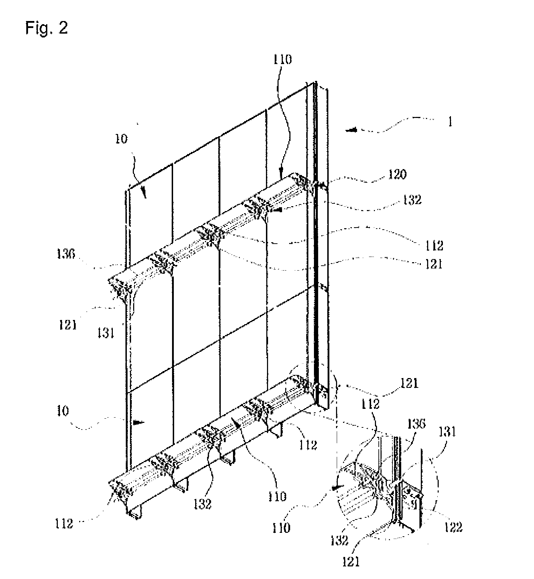

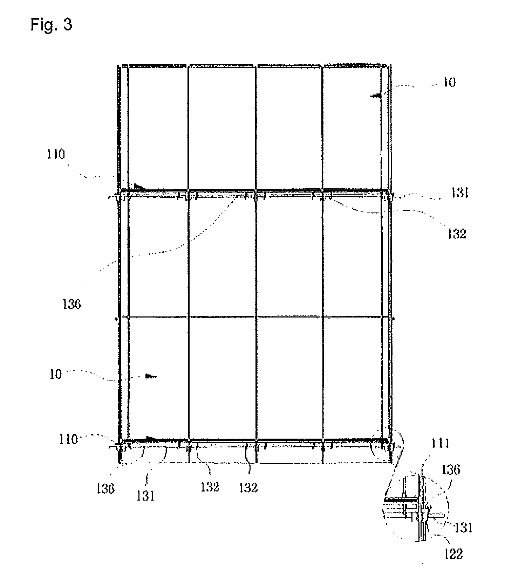

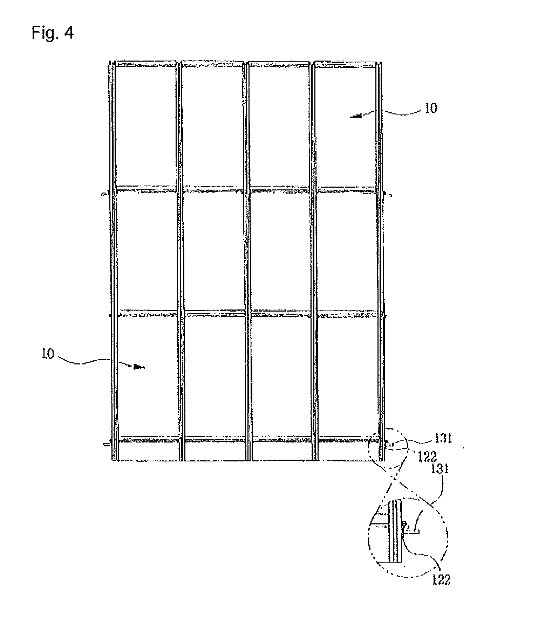

As shown in Figures 1 through 4, the sunlight-collecting apparatus 1 comprises a reflection panel 110 installed at a lower side of a sunlight-collecting panel 10 installed at an outer wall of a building, a support part 120 which is coupled to the reflection panel 110, and an operation part 130 enhancing a sunlight-collecting efficiency by adjusting the angle of the reflection panel 110.

The reflection panel 110 is characterized in that an angle adjusting frame 112 with a shaft hole 115 is coupled to its lower surface, and an insertion piece 113 with a pin hole 114 is formed in such a way to protrude an end portion of the angle adjusting frame 112 toward a building.

It is preferred that the reflection surface 111 of the upper surface of the reflection panel 110 is curved, and the front and rear sides of the same are formed in staircase shapes, thus allowing foreign substances to easily flow downwards, and the solar energy can be more efficiently reflected toward the sunlight-collecting panel 10.

The reflection surface 111 of the reflection panel 110 is preferably coated with a self-cleaning coating agent having an excellent reflection performance.

The support part 120 is horizontally installed in multiple numbers in such a way to couple the fixing frame 121 to each frame of an outer wall of the building, and a rotation guide member 122 with a shaft hole 123 is coupled to the fixing frame 121, and a shaft hole 124 is formed at an outer side of the rotation guide member 122.

It is preferred that a coupling chassis 125 is vertically formed at a rear side of the fixing frame 121 and is slide-coupled to the frame of the building.

It is preferred that a fixing member 126 is formed at the fixing frame 121 of left and right sides installed at an outer wall of a building and is inserted into the interior of the frame of the building.

The operation part 130 is engaged in such a way that a rotation shaft 131 is inserted into the shaft hole 123 of the rotation guide member 122 formed at the fixing frame 121, and one side of the connection piece 132 is coupled to left and right sides or one side of the rotation guide member 122, thus cooperating with the rotation shaft 131.

A pin hole 132b is formed at the other side of the connection piece 132, and one side of the connection bar 133 of which each end has a pin hole 133b is pin-coupled to the connection piece 132 by way of a connection pin 132b.

An adjusting part 134 having a pin hole 134b is pin-coupled to the other side of the connection bar 133 by way of a connection pin 133b.

An insertion groove 134a is formed at the adjusting part 134 and is pin-coupled by matching the pin hole 133b of the connection bar 133, the pin hole 114 formed at the insertion piece 113 of the angle adjusting frame 112 and the pin hole 134b of the adjusting part 134.

The operation part 130 is equipped with a guide shaft 136, thus being inserted into the shaft hole 115 of the angle adjusting frame 112.

When the rotation shaft 131 rotates, the connection piece 132 rotates in sync, thus pushing or pulling the connection bar 133.

So, the adjusting part 134 pin-coupled to the connection bar 133 moves upwards or downwards, and the angle adjusting frame 112 rotates about the guide shaft 136, thus adjusting the angle of the reflection panel 110 coupled to an upper side of the angle adjusting frame 112 and effectively reflecting solar energy toward the sunlight-collecting panel 10.

A connection rod 135 is coupled, in an upward direction, to the adjusting part 134 of the operation part 130 for a connection with the adjusting part 134 installed at the upper side and for a cooperation with the same, thus concurrently adjusting the reflection panels 110 of the upper and lower sides.

A motor is coupled to one side or left and right sides of the rotation shaft 131 of the operation part 130, and it is possible to select and use a pulse motor, a decelerator or the like.

The angle adjusting of the reflection panel 110 by means of the operation part 130 is performed by means of a memory sensor (not shown) installed at the operation part 130. The memory sensor is a kind of the sensor with a Read Only Memory (ROM) in which all the data, to be used for the next tens of years, concerning when the sun rises and sets and the angles that the sun lights per a second in the region where the sunlight-collecting apparatus according to the present invention is installed.

The operations of the present invention will be described.

First of all, when constructing an outer wall of a building, a sunlight-colleting panel 10 is installed at an outer wall between floors, and a reflection panel 110 is installed at a lower side of the sunlight-collecting panel 10 in the above construction, the construction of which allows solar energy to reflect toward the sunlight-collecting panel 10, thus enhancing a sunlight collecting efficiency.

The sunlight-collecting apparatus according to the present invention is directed to adjusting the angles of the reflection panel to the optimum reflection angle depending on the changes in positions of the sun.

The rotation shaft 131 is driven to rotate in a normal or reverse direction by controlling the motor installed at the operation part 130.

The normal or reverse direction rotation is performed in sync with the connection piece 132 coupled to the rotation shaft 131.

The connection bar 133 pin-coupled to the connection piece 132 moves upwards or downwards, by the operation of which the adjusting part 134 pin-coupled to the connection bar 133 moves upwards or downwards.

Since the pin hole 133b of the connection bar 133, the pin hole 114 formed at the insertion piece 113 of the angle adjusting frame 112 and the pin hole 134b of the adjusting part 134 are all together pin-coupled at the insertion groove 134a of the adjusting part 134, so the angle adjusting frame 112 rotates in a normal or reverse direction about the guide shaft 136, by means of which the angle of the reflection panel 110 coupled to the upper side of the angle adjusting frame 112 can be adjusted, thus effectively reflecting solar energy toward the sunlight-collecting panel 10.

The angle adjusting of the reflection panel 110 is conducted by controlling the motor depending on a sunrise time and a sunset time of a corresponding date in the region and the incident angles of sunlight obtained by the unit of second at a corresponding time based on the values stored in the memory sensor. At the night time or rainy time without sunlight, the memory sensor recognizes that there is not light and allows the angle of the reflection panel 110 to be below 45°, thus preventing the contaminations of the reflection panel 110 from rainwater, dusts or the like.

A self-cleaning coating agent with an excellent reflection performance is coated on the reflection surface 111 of the reflection panel 110, so it is possible to maintain for a long time by in maximum inhibiting the creations of the foreign substances.

### Industrial applicability

The present invention provides a sunlight-collecting apparatus which can be usefully applied to an energy field now that a sunlight-collecting panel is installed at an outer wall between the floors of a building, and a reflection panel at a lower side of a sunlight-collecting panel, thus effectively collecting sunlight and enhancing a power generation efficiency of solar energy.

The present invention provides a sunlight-collecting apparatus which can significantly enhance a power generation of solar energy by effectively collecting sunlight in such a way to adjust the angle of a reflection panel installed at a lower side of a sunlight-collecting panel of an outer wall of a building, so the present invention can be usefully applied to energy field.

## Claims

1. A sunlight-collecting apparatus, comprising:
a reflection panel 110 which is installed at a lower side of a sunlight-collecting panel 10 installed at an outer wall of a building and has an angle adjusting frame 112 engaged thereto and having a shaft hole 115 formed at its lower surface, and has an insertion piece 113 with a pin hole 114, the insertion piece 113 being formed by projecting a rear end of the angle adjusting frame 112 toward the building;
a support part 120 which supports the reflection panel 110 and is horizontally provided in multiple numbers by coupling the fixing frame 121 at each frame of an outer wall of the building and forms a shaft hole 124 at an outer side of the rotation guide member 122 by coupling the rotation guide member 122 at the fixing frame 121; and
an operation part 130 helping enhance a sunlight-collecting efficiency by adjusting the angle of the reflection panel 110, and a rotation shaft 131 is inserted into and coupled to the shaft hole 123 of the rotation guide member 122 formed at the fixing frame 121, and a connection piece 132 is coupled to the rotation shaft 131, and an adjusting part 134 is pin-coupled to the connection piece 132 by way of a connection bar 133 for cooperation, and the insertion pieces 113 of the connection bar 133 and the angle adjusting frame 112 are concurrently pin-coupled to the adjusting part 134, and the guide shaft 136 is coupled to the shaft hole 115 of the angle adjusting frame 112.

2. A sunlight-collecting apparatus according to claim 1, wherein a reflection surface 111 of the reflection panel 110 is formed in a staircase shape in its front and rear sides and is curved, with a self-cleaning coating agent being coated on the surfaces.

3. A sunlight-collecting apparatus according to claim 1, wherein an engaging chassis 125 and a fixing member 126 are formed at a rear side of the fixing frame 121 of the support part 120,

4. A sunlight-collecting apparatus according to claim 1, wherein a connection rod 135 is coupled, in an upward direction, to the adjusting part 134 of the operation part and then is connected with the adjusting part 134 installed at an upper side for cooperation.
